(19) Europäisches Patentamt
European Patent Office
Office européen des brevets

(11) EP 1 666 515 B1

(12) **EUROPEAN PATENT SPECIFICATION**

(45) Date of publication and mention of the grant of the patent:
**22.02.2012 Bulletin 2012/08**

(21) Application number: **04787901.0**

(22) Date of filing: **17.09.2004**

(51) Int Cl.:
***C08G 59/02*** *(2006.01)* ***C08G 59/14*** *(2006.01)*
***C08G 59/24*** *(2006.01)*

(86) International application number:
**PCT/JP2004/013646**

(87) International publication number:
**WO 2005/028536 (31.03.2005 Gazette 2005/13)**

# (54) ALICYCLIC EPOXY RESIN, PROCESS FOR PRODUCING THE SAME, COMPOSITION THEREOF, CURED EPOXY RESIN, AND USE OF ALICYCLIC EPOXY RESIN COMPOSITION

ALICYCLISCHES EPOXIDHARZ, HERSTELLUNGSVERFAHREN DAFÜR, ZUSAMMENSETZUNG DAVON, GEHÄRTETES EPOXIDHARZ UND VERWENDUNG VON ALICYCLISCHES EPOXIDHARZ ENTHALTENDER ZUSAMMENSETZUNG

RESINE EPOXY ALICYCLIQUE, SON PROCEDE DE PRODUCTION, COMPOSITION LA COMPRENANT, RESINE EPOXY DURCIE ET UTILISATION DE LA COMPOSITION DE RESINE EPOXY ALICYCLIQUE

(84) Designated Contracting States:
**DE**

(30) Priority: **22.09.2003 JP 2003330147**
**24.09.2003 JP 2003331822**

(43) Date of publication of application:
**07.06.2006 Bulletin 2006/23**

(73) Proprietor: **Mitsubishi Chemical Corporation**
**Tokyo (JP)**

(72) Inventors:
- **MURAI, Kouya,**
**c/o MITSUBISHI CHEMICAL CORPORATION**
**Yokkaichi-shi,**
**Mie 510-8530 (JP)**
- **OONUMA, Yoshinobu,**
**c/o JAPAN EPOXY RESINS CO., LTD**
**Yokkaichi-shi,**
**Mie 510-0851 (JP)**

(74) Representative: **HOFFMANN EITLE**
**Patent- und Rechtsanwälte**
**Arabellastraße 4**
**81925 München (DE)**

(56) References cited:

| | |
|---|---|
| **EP-A- 0 921 141** | **EP-A- 1 270 633** |
| **JP-A- 10 110 102** | **JP-A- 2003 040 972** |
| **JP-A- 2003 082 062** | **JP-A- 2003 212 959** |
| **JP-A- 2004 168 719** | **US-A- 6 060 611** |

- **DATABASE WPI Week 200132 Thomson Scientific, London, GB; AN 2001-303694 XP002512789 -& JP 2001 019742 A (YUKA SHELL EPOXY KK) 23 January 2001 (2001-01-23)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 666 515 B1

## Description

### TECHNICAL FIELD

The present invention relates to a process for producing alicylic epoxy resins which are solid at normal temperature and useful as a base substance for the optical materials, coating materials, etc., by hydrogenating the aromatic rings of aromatic epoxy resins.

The epoxy resin produced by the invention can be used in epoxy resin compositions which, as capable of providing a colorless and transparent cured product with excellent crack resistance and light resistance, can be used for coating materials, light-curing materials and electric and electronic materials related to photo-semiconductors such as LED (light emitting diodes) and CCD, especially epoxy resin compositions useful for sealing LEDs which emits light of a short wavelength, epoxy resin cured products obtained by curing the said epoxy resin compositions, and sealants for luminous element comprising the said epoxy resin compositions.

### BACKGROUND ART

Since epoxy resins are excellent in heat resistance, adhesiveness, water resistance, mechanical strength and electrical properties, they have been used for a wide variety of industrial products such as adhesive agents, coating materials, engineering and construction materials and insulating materials for electric and electronic parts. As common epoxy resins used for these applications, aromatic epoxy resins such as bisphenol A epoxy resins, bisphenol F epoxy resins and phenolic or cresol novolak epoxy resins are mentioned. Also, the aromatic epoxy resins obtained from various phenolic compounds are used according to the objective product.

Also alicyclic epoxy resins are produced by the various methods, such as epoxidizing the carbon-carbon double bonds, reacting a polyhydric alicyclic alcohol with epihalohydrin, or hydrogenating the aromatic rings (hereinafter referred to as "nuclear hydrogenation") of an aromatic epoxy resin, and used.

In these alicyclic epoxy resins, particularly the hydrogenated epoxy resins obtained from the aromatic epoxy resins by subjecting them to nuclear hydrogenation are expected to find application to sealing materials, optical materials, coating materials, adhesives, etc., for instance sealant for luminous materials such as light-emitting diodes, because these hydrogenated epoxy resins excel in light resistance and transparency of their cured products and cationic curing characteristics and are also few in impurities such as chlorine compounds.

Various proposals have been made on the method of producing the hydrogenated epoxy resins by means of nuclear hydrogenation of the aromatic epoxy resins. For instance, the following methods are known: Nuclear hydrogenation of an aromatic epoxy resin is carried out in the presence of a hydrogenation catalyst prepared by having rhodium or ruthenium supported on an inert carrier such as activated carbon (Patent Document 1); Nuclear hydrogenation is carried out using a catalyst supporting ruthenium and a metal with high electronegativity (Patent Document 2); Nuclear hydrogenation is conducted by using a catalyst comprising a rhodium- or ruthenium-supporting carbonaceous carrier having a specific surface area in the range of 5 to 600 $m^2/g$ (Patent Document 3). A low-chlorine-content epoxy resin with a high nuclear hydrogenation rate and small in loss of epoxy groups (namely, suppressed in decomposition in the nuclear hydrogenation reaction) has been proposed (Patent Document 4). A proposal has also been made relating to the hydrogenated epoxy resins which are few in impurities and excel in light transmittance (Patent Document 5).

However, many of these proposals relate to nuclear hydrogenation of the general-purpose bisphenol A type or bisphenol F type low-molecular weight epoxy resins, and the obtained hydrogenated epoxy resins are liquid at normal temperature and mostly used as a composition for liquid sealing, casting or such purposes.

On the other hand, the aromatic epoxy resins with a high molecular weight are solid at normal temperature, and nuclear hydrogenation thereof provides the hydrogenated epoxy resins which are solid at normal temperature. Some documents (Patent Documents 1, 2 and 6) discuss nuclear hydrogenation of the high-molecular weight aromatic epoxy resins, but the high-molecular weight aromatic epoxy resins are low in reactivity as compared to the low-molecular weight aromatic epoxy resins and therefore involve greater difficulties in their nuclear hydrogenation. In the conventional methods, therefore, it was necessary to carry out the reaction under a condition of high pressure, low temperature and low concentration for suppressing decomposition in the nuclear hydrogenation reaction. It was also required to use the catalyst in large quantities relative to the epoxy resin and to conduct the reaction for a long time for effectuating the desired nuclear hydrogenation, resulting in an elevated cost for catalyst and a reduction of productivity to provide poor economy.

Further, in nuclear hydrogenation of the high-molecular weight aromatic epoxy resins, it has been difficult to obtain the hydrogenated epoxy resins which are satisfactory in general properties such as nuclear hydrogenation rate, epoxy group retention rate and hue, and in the conventional methods, although a nuclear hydrogenation rate of 80 to 96% was reported (Patent Documents 1, 2 and 6), there has been no instance where a high-molecular weight aromatic epoxy resin with an epoxy equivalent of 500 or more was reacted at a nuclear hydrogenation rate of 95% or higher.

Further, no sufficient disclosure has been made regarding appearance and properties of the obtained hydrogenated epoxy resins, and these resins were in most cases tinted by the residual catalyst or other causes and unsuited for the applications where transparency was required.

Resin sealing is used for most of the luminous devices such as photo-semiconductors (LED) which have been put to practical use in recent years for various types of display boards, light source for image reading, traffic signals, large-sized display units, etc. The sealing resins used for these devices comprise generally an aromatic epoxy resin mentioned above and an alicyclic acid anhydride used as a curing agent. The resin cured products used for sealing these LED elements, however, are prone to crack in the cooling-heating cycles and therefore have problems in use under the severe conditions.

Also, phenomenal progress of LED technology in recent years has realized rapid development in the efforts for higher output of LED elements and shorter wavelength of the emitted light, and particularly LED using a nitride semiconductor has become capable of short-wavelength and high-output light emission and its practical use is on course. However, when an LED element using a nitride semiconductor is sealed with an aromatic epoxy resin, there takes place deterioration of the sealing resin with the lapse of time because of absorption of short-wavelength light by the aromatic rings, giving rise to the problem of sharp drop of luminance of emitted light due to yellowing.

As a solution to this problem, LED sealed by using an alicyclic epoxy resin obtained by oxidizing a cyclic olefin, such as 3,4-epoxycyclohexylmethyl-3',4'-epoxycyclohexane carboxylate, has been proposed (Patent Documents 7 and 8). However, the cured product of this alicyclic epoxy resin was very fragile and likely to crack or break in the cooling-heating cycles and was also very bad in moisture resistance, so that it was unsuited for uses where long-time reliability was required.

There has then been proposed an LED sealed with a resin composition comprising, as base, a liquid hydrogenated bisphenol A epoxy resin and, incorporated therein, an alicyclic epoxy resin and a phosphoric anti-oxidant, with a methylhexahydrophthalic acid anhydride being used as a curing agent (Patent Document 9). However, this epoxy resin cured product, although colorless and transparent, is still fragile and unsatisfactory for use for sealing the LED elements which are required to be resistant to cracks in particular.

An effective method for continuously sealing LED's is to use a low pressure transfer molding machine in sealing LED's. According to this method, since a solid LED sealant is used, it is possible to seal LED's in bulk with higher productivity than capable with use of a liquid LED sealant. Further, because of use of a high-molecular weight epoxy resin, the obtained epoxy cured product is very tough and greatly improved in crack resistance. Usually the epoxy resin for this solid LED sealant is produced by using a high-molecular weight bisphenol A epoxy resin, an acid anhydride compound as a curing agent and a curing accelerator and kneading them continuously by a kneader.

However, since the aromatic epoxy resins, as mentioned above, had the problem that their aromatic rings absorb light of short wavelength to cause deterioration of the resins, the development of a high-molecular alicyclic epoxy resin with excellent light stability has been desired. In order to meet this requirement, it has been suggested to obtain a high-molecular weight alicyclic epoxy resin by conducting nuclear hydrogenation of a high-molecular weight aromatic epoxy resin, but as mentioned above, nuclear hydrogenation of a high-molecular weight aromatic epoxy resin is very difficult, and the obtained hydrogenated epoxy resin is unsatisfactory in nuclear hydrogenation rate, epoxy group retention rate and hue. In addition, such a tinted epoxy resin is unsuited for use for sealing a luminous element which is required to have light resistance in addition to transparency.

Patent Document 1: U.S. Patent No. 3,336,241
Patent Document 2: Japanese Patent Application Laid-Open (KOKAI) No. 10-204002
Patent Document 3: Japanese Patent Application Laid-Open (KOKAI) No. 11-217379
Patent Document 4: Japanese Patent Application Laid-Open (KOKAI) No. 11-199645
Patent Document 5: Japanese Patent Application Laid-Open (KOKAI) No. 2003-81957
Patent Document 6: EP-545154 A1
Patent Document 7: Japanese Patent Application Laid-Open (KOKAI) No. 9-213997
Patent Document 8: Japanese Patent Application Laid-Open (KOKAI) No. 2000-196151
Patent Document 9: Japanese Patent Application Laid-Open (KOKAI) No. 2003-12896

## DISCLOSURE OF THE INVENTION

## SUBJECTS TO BE SOLVED BY THE INVENTION

Thus, subjects to be solved by the present invention are to provide a process for producing hydrogenated alicyclic epoxy resins, which are obtained by the nuclear hydrogenation of an aromatic epoxy resin, have a high nuclear hydrogenation rate and excellent transparency, are solid at normal temperature, and are useful for optical materials and coating materials.

## MEANS FOR SOLVING THE PROBLEMS

The essential points of the present invention are as described below.

In one aspect of the present invention, there is provided a process for producing an alicyclic epoxy resin which comprises nuclear hydrogenation of an aromatic epoxy resin in the presence of a catalyst containing a platinum group element, wherein
the epoxy equivalent of said aromatic epoxy resin is from 500 to 10,000,
the total content of alkaline metals and group XV elements of said aromatic epoxy resin is not more than 10 ppm, and said catalyst containing a platinum group element is offered to the reaction as a catalyst precursor in a non-reduced state, prepared by supporting a platinum group element compound on a carrier.

## EFFECT OF THE INVENTION

According to the present invention, it is possible to produce alicyclic epoxy resins having a high nuclear hydrogenation rate and excellent transparency and solid at normal temperature. It is particularly noteworthy that by use of a specific hydrogenation catalyst, such alicyclic epoxy resins can be produced efficiently at low cost with a minimized catalyst requirement, so that the present invention is quite beneficial to the industry.

Also, the cured products of the epoxy resin compositions obtainable on the basis of the present invention are colorless and transparent and have excellent crack resistance, so that such products hardly crack in the cooling-heating cycle tests. Further, the products obtainable in the present invention excel in light and heat resistance, so that they can be advantageously used as an epoxy resin composition for sealant of LED's in transfer molding, particularly for sealing LED's using a group III element nitride semiconductor which emits light of a short wavelength.

## BEST MODE FOR CARRYING OUT THE INVENTION

The embodiments of the present invention will be described in detail below.

[Alicyclic epoxy resins and their production process]

First, for the convenience of explanation, a process for producing an alicyclic epoxy resin is explained. The alicyclic epoxy resin production process according to the present invention features nuclear hydrogenation of an aromatic epoxy resin in which the epoxy equivalent of the said aromatic epoxy resin is 500 to 10,000, and the total content of alkaline metals and group XV elements of the said aromatic epoxy resin is not more than 10 ppm.

It is possible to proceed the nuclear hydrogenation smoothly at a high hydrogenation rate by using as the starting material an aromatic epoxy resin whose epoxy equivalent is specified as mentioned above and in which the total content of alkaline metal elements and Periodic Table group XV elements (which may hereinafter be referred to as "specific impurity elements") is also defined. By carrying out such nuclear hydrogenation of an aromatic epoxy resin at a high hydrogenation rate, there can be obtained an alicyclic epoxy resin which is solid at normal temperature and has high transparency.

The alkaline metal element designated as one of the specific impurity elements in the present invention is, to be more definite, an element selected from the group consisting of lithium, sodium and potassium, and the Periodic Table group XV element is defined to be nitrogen and/or phosphorus. In the present invention, nuclear hydrogenation is carried out in the presence of a catalyst containing a platinum group element. This catalyst containing a platinum group element is one obtained by reducing a catalyst precursor comprising a carrier supporting a platinum group element compound. In conducting reduction of the catalyst precursor, an aromatic epoxy resin is allowed to coexist so that both reduction of the catalyst precursor and nuclear hydrogenation reaction of the aromatic epoxy resin may be carried out simultaneously with each other in a same reaction system. The amount of the catalyst used in the reaction is preferably 0.001 to 0.5% by weight in terms of the ratio of the platinum group element to the aromatic epoxy resin.

Thus, by using a specific catalyst in a specified quantity, it is possible to produce a highly transparent, high-nuclear-hydrogenation-rate solid alicyclic epoxy resin at high efficiency with a minimized amount of catalyst.

The alicyclic epoxy resin production process according to the present invention preferably comprises a nuclear hydrogenation step in which the aromatic rings of an aromatic epoxy resin are hydrogenated in the presence of a hydrogenation catalyst, and a refining step in which the hydrogenated epoxy resin is taken out from the reaction mixture.

(Aromatic epoxy resins subjected to nuclear hydrogenation)

The aromatic epoxy resins used in the present invention has an epoxy equivalent of 500 to 10,000 and the total content of the specific impurity elements, viz. alkaline metal elements and Periodic Table group XV elements of

not more than 10 ppm, and are usually solid at normal temperature.

If the epoxy equivalent of the aromatic epoxy resin subjected to nuclear hydrogenation is less than 500, the obtained hydrogenated epoxy resin may become liquid or half solid which is low in softening point and excessively sticky. If its epoxy equivalent exceeds 10,000, the nuclear hydrogenation rate lowers.

The aromatic epoxy resins used in the present invention are also defined to be ones in which the total content of alkaline metal elements and Periodic Table group XV elements does not exceed 10 ppm. The reason for imposing such definition on the content of the specific impurity elements in the starting aromatic epoxy resin is as explained below.

Generally, for producing a high-molecular weight aromatic epoxy resin, either of the following methods (1) or (2), both being used industrially, is adopted.

(1) In the production process (one-stage process) in which a bisphenol compound and epihalohydrin are subjected to condensation reaction in the presence of an alkaline compound, the ratio of epihalohydrin to the bisphenol compound is lessened to increase the molecular weight of the resin.

(2) A low-molecular weight epoxy resin produced by the one-stage process and a bisphenol compound are reacted in the presence of a basic catalyst to thereby increase the molecular weight of the resin (two-stage process).

The alkaline compound used in the one-stage process is an inorganic basic compound such as lithium hydroxide, sodium hydroxide, potassium hydroxide, sodium carbonate, potassium carbonate or the like, and usually an aqueous solution of sodium hydroxide is used in an amount of not less than equivalent to the epoxy group. In the case of the one-stage process, an alkaline compound is used in an amount of not less than equivalent to the reacting weight of epihalohydrin. The by-product alkali halide is filtered away, and if necessary the salts are removed by suitable means such as washing with water.

In the two-stage process, on the other hand, as the basic catalyst applied for accelerating the addition reaction of the epoxy groups and the phenolic hydroxyl groups, there can be used, for instance, tertiary amines such as triethylamine, tributylamine and benzyldimethylamine, quaternary ammonium salts such as tetraethylammonium chloride, tetraethylammonium bromide and tetrabutylammonium bromide, phosphines such as tributylphosphine, triphenylphosphine and tris(dimethoxyphenyl)phosphine, quaternary phosphonium salts such as tetraethylphosphonium bromide, tetrabutylphosphonium bromide and tetrabutylphosphonium iodide, and inorganic basic compounds such as lithium hydroxide, lithium hydroxide, potassium hydroxide, sodium carbonate and potassium carbonate. Such a catalyst is used in an amount of several hundred ppm based on the starting epoxy resin. In the case of the epoxy resin obtained from the two-stage process, usually the basic catalyst used as an addition reaction accelerator is not separated from the product. This is for the reason of simplifying the production of the epoxy resin, or because the remaining basic catalyst presents no serious problem in other uses.

However, the present inventors have found that when a nuclear hydrogenation reaction is carried out by using as starting material an aromatic epoxy resin with an epoxy equivalent of 500 to 10,000 obtained from the said one-stage or two-stage process, the compound containing a small quantity of an alkaline metal element or a Periodic Table group XV element, particularly a basic substance could poison the nuclear hydrogenation catalyst to retard and finally stop the hydrogenation reaction, providing no improvement of the nuclear hydrogenation rate of the epoxy resin. Against this, if the product is refined after the end of the synthesis reaction of the said high-molecular weight aromatic epoxy resin to give an aromatic epoxy resin having the total content of the alkaline metal element and the Periodic Table group XV element of not more than 10 ppm, and this aromatic epoxy resin with a reduced content of specific impurity elements is subjected to nuclear hydrogenation, it is possible to obtain a solid hydrogenated epoxy resin with a high hydrogenation rate.

No specific restrictions are imposed on the way of obtaining an aromatic epoxy resin having the total content of alkaline metal elements and Periodic Table group XV elements of not more than 10 ppm; there can be used, for instance, the following methods: the reaction product obtained from the one-stage or two-stage process is refined by washing once or twice or more than twice with purified water; in the two-stage process, the reaction product obtained from the one-stage process is refined by washing once or twice or more than twice with purified water and then further increased in molecular weight, and its reaction product is again washed once or twice or more than twice with purified water for refining. It is also possible to use solvent washing in which prior to washing with purified water, the aromatic epoxy resin is dissolved in an appropriate organic solvent and then the organic solvent is distilled away. In this case, methyl isobutyl ketone, toluene, xylene or the like may be used as the organic solvent. The specific impurity element content can be also reduced by a method in which the reaction product is subjected to an adsorption treatment using an adsorbent such as activated carbon.

In the specific impurity elements, the alkaline metal elements are lithium (L), sodium (Na) and potassium (K), and the Periodic Table group XV elements are nitrogen (N) and phosphorus (P). In the present invention, it is preferable to use as starting material an aromatic epoxy resin in which the contents of the individual elements are not more than 5 ppm, with the total content of all the elements (viz. the combined content of Li, Na, K, N and P) of not more than 10

ppm, preferably not more than 7 ppm, especially not more than 5 ppm, because it provides an enhancement of nuclear hydrogenation rate with certainty. Conventional methods can be used for the analyses of the impurity elements in the epoxy resin. For example, ICP emission spectroscopic analysis, ICP-MS analysis or such means may be used for the analyses of the alkaline metal elements and phosphorus, while a total nitrogen analyzer can be used for the analysis of nitrogen.

Examples of the aromatic epoxy resins usable in the present invention include bisphenol epoxy resins such as bisphenol A epoxy resins, bisphenol F epoxy resins, 3,3',5,5'-tetramethyl-4,4'-biphenol epoxy resin and 4,4'-biphenol epoxy resin, bisphenol A novolak resins, and naphthalenediol epoxy resins. These aromatic epoxy resins may be used alone or as a mixture of two or more.

Of these aromatic epoxy resins, bisphenol A epoxy resins and bisphenol F epoxy resins, with an epoxy equivalent of 600 to 6,000 are preferred, and those produced by the one-stage process are especially preferred as they can derive the maximum effect of the present invention.

(Hydrogenation catalyst)

<Catalyst components>

The hydrogenation catalyst used in the present invention is a catalyst containing a platinum group element such as, for instance, ruthenium, rhodium, palladium, osmium, iridium and platinum. A rhodium (Rh) catalyst or a ruthenium (Ru) catalyst is more preferred, with a rhodium catalyst being especially preferred.

These catalysts are used, usually because of high activity, in the form of supported-type catalysts having a platinum group element (platinum group metal) or a compound thereof supported on a carrier.

<Carrier>

As the carrier, for instance carbonic carriers and inorganic oxides such as alumina, silica, zeolite, etc., can be used, with carbonic carriers being preferred. The form of the catalyst may be powder, pellets, etc., but powder is preferred. The particle size of the powder is usually 1 to 1,000 μm, preferably 5 to 500 μm.

Examples of the carbonic carriers are activated carbon, graphite and carbon black. Graphite, especially one called high surface area graphite is preferably used. The specific surface area of the high surface area graphite carrier is usually 5 to 2,000 $m^2/g$, preferably 50 to 600 $m^2/g$.

<Platinum group metal compounds>

The platinum group metal compounds usable as a hydrogenation catalyst in the present invention include the inorganic and organic acid salts of platinum group metals, coordination compounds, and organic metal compounds including platinum group metal, but the inorganic and organic acid salts of platinum group metals are preferred in view of easy availability. Specifically, in case where rhodium is used as platinum group metal, as examples of the rhodium-containing compounds, rhodium chloride, rhodium nitrate, rhodium sulfate, rhodium acetate, rhodium acetylacetonate, tetrarhodium dodecacarbonyl and the like can be cited. Rhodium chloride, rhodium nitrate and rhodium acetate are especially preferred.

<Amount supported>

The amount of a platinum group metal to be supported on a carrier, although variable depending on the compound used, the type of the carrier, the way of supporting, etc., is usually 0.1 to 50% by weight, preferably 0.5 to 20% by weight, more preferably 1 to 10% by weight based on the carrier, calculated in terms of metal.

<Way of supporting>

As for the way of supporting a platinum group metal-containing compound on a carrier, it is possible to properly select from the various commonly used methods. For instance, impregnation method or ion exchange method such as described in Chemistry of Catalyst Preparation (Kodansha Scientific, 1982), p. 49, can be used.

In an example of the supporting methods, a platinum group metal compound is dissolved in a solvent capable of dissolving the compound, such as water, alcohol, hydrocarbon, etc., to prepare a solution, and this solution is impregnated in a carrier. If necessary, in order to provide securer fixation of the metal compound to the carrier, an inorganic basic compound, a nitrogen-containing organic compound or the like, such as sodium hydroxide or ammonia, may be used to adjust pH to a pertinent value. In this case, it is considered that the platinum group compound is supported in

the form of a hydroxide or oxide on the carrier.

After the impregnation, the solvent is removed by filtration or evaporation and the inorganic basic compound or the like used for the fixation is washed with a solvent, after which, if necessary, the result product is dried to provide a catalyst having a platinum group metal compound supported on a carrier.

In the above reaction, the catalyst is subjected directly to the nuclear hydrogenation reaction. In the case of the catalyst of a non-reduced state offered to the reaction, it is considered that substantially the catalytic activity is generated after the catalyst has been reduced under the nuclear hydrogenation reaction condition.

<Particularly preferred hydrogenation catalyst>

In a particularly preferred hydrogenation catalyst preparation method in the present invention, a carbonic carrier is impregnated with an aqueous solution of a rhodium compound, then an alkaline compound is added to have the rhodium compound supported on the carbonic carrier, and the thus obtained supported catalyst is separated into solid and liquid, after which the impurities are removed by washing with water and, if necessary, the resulting product is dried.

When this catalyst is used without reduction for the nuclear hydrogenation reaction, the rhodium compound is reduced to an active state in the nuclear hydrogenation reaction system (in a liquid phase in the presence of hydrogen gas) to produce a high activity, making it possible to let the nuclear hydrogenation reaction proceed effectively with less usage of catalyst.

(Nuclear hydrogenation reaction)

The nuclear hydrogenation reaction is carried out by reacting an aromatic epoxy resin with hydrogen in the presence of a reaction solvent and a nuclear hydrogenation catalyst mentioned above.

The amount of the nuclear hydrogenation catalyst used for the reaction may be properly selected within the range where a practical reaction rate can be obtained, by taking into account the various conditions such as reaction temperature and reaction pressure. When the catalyst is used in large quantities, although the reaction can be accomplished at a low temperature, under a low pressure and in a short time, the cost for the catalyst elevates to impose an economical problem. On the other hand, when the amount of the catalyst used is too small, the reaction rate lowers, making it difficult to let the reaction proceed and complete within a normal scheduled period of time. Preferably the catalyst is used in an amount of 0.001 to 0.5 part by weight, more preferably 0.002 to 0.2 part by weight, even more preferably 0.003 to 0.1 part by weight, calculated in terms of the amount of the active metal (platinum group element), to 100 parts by weight of the aromatic epoxy resin. Thus, in case where, for instance, a catalyst supporting 5% by weight of an active metal is used as the hydrogenation catalyst, the amount of the catalyst used, including the supported metal, is 0.02 to 10 parts by weight, preferably 0.04 to 4 parts by weight, more preferably 0.06 to 2 parts by weight, to 100 parts by weight of the aromatic epoxy resin.

As the nuclear hydrogenation reaction solvent, those which are stable to hydrogenation and non-poisonous to the catalyst, such as ether type solvents, ester type solvents, alcoholic solvents and paraffinic solvents can be used. Preferred examples of such solvents are chain or cyclic ethers such as diethyl ether, isopropyl ether, methyl-t-butyl ether, ethylene glycol dimethyl ether, tetrahydrofuran, dioxane and dioxolan; esters such as ethyl acetate and butyl acetate; and ether esters such as ethylene glycol methyl ether acetate. These solvents may be used alone or as a mixture of two or more. In these solvents, the ether and ester type solvents are preferred, with the ester type being especially preferred.

As the ester type solvents, the fatty acid esters having a boiling point in the range of 50 to 180°C under normal pressure, especially acetic esters and propionic esters are preferred for the ease of handling. Preferred examples of such esters are ethyl acetate, propyl acetate, butyl acetate and methyl propionate, with ethyl acetate being especially preferred.

The amount of the reaction solvent used, in weight ratio to the starting aromatic epoxy resin, is usually 0.1 to 20, preferably 0.5 to 10. If the amount of the reaction solvent is too small, since the starting aromatic epoxy resin is usually high in viscosity, the hydrogen diffusion fails to proceed in a satisfactory way, causing a drop of reaction rate or a reduction of selectivity of the nuclear hydrogenation reaction. If the amount of the reaction solvent is too large, the reaction vessel needs to be enlarged in size, causing a disadvantage to the recovery of the product. A large amount of solvent is required particularly in case where an aromatic epoxy resin with a large molecular weight and a high melt viscosity is used as the starting material, but use of a too much amount of reaction solvent leads to a drop of productivity and an economical disadvantage.

The reaction temperature is usually 30 to 150°C, preferably 50 to 130°C. A too low reaction temperature causes a drop of reaction rate, necessitating a large amount of hydrogenation catalyst and a prolonged period of time for completing the reaction. On the other hand, a too high reaction temperature encourages the occurrence of side reactions such as hydrogenolysis of epoxy groups, resulting in a degraded product quality. The pressure used for the reaction is

usually 1 to 30 MPa, preferably 2 to 15 MPa. A too low reaction pressure leads to a reduced reaction rate, necessitating use of a large amount of hydrogenation catalyst and a long time for completing the reaction. A too high reaction pressure necessitates scale-up of the necessary equipment, resulting in an economical disadvantage.

As for the reaction system, it is possible to use either liquid phase suspension reaction or fixed bed reaction, the former being preferred. Hydrogen may be introduced by continuous feed or only an amount to be consumed may be supplied. Also, hydrogen may be introduced into the liquid to disperse, or it may be engulfed in and absorbed into the liquid from the vapor phase by suitable means such as stirring.

The end point of the nuclear hydrogenation reaction can be judged by monitoring of hydrogen absorption or a sampling analysis.

(Method of after-treatment)

After the completion of the reaction, the catalyst is separated from the reaction mixture by a suitable operation such as filtration or centrifuging, and then the reaction solvent is distilled away to obtain the objective product.

However, mere separation of the catalyst from the reaction mixture after the completion of the nuclear hydrogenation reaction leaves a possibility that the obtained hydrogenated epoxy resin could be tinted by elution of the active metal from the catalyst or other causes to induce a drop of light transmittance of the resin, so that it is preferable to subject the reaction product to a treatment with an adsorbent before distilling away the solvent. In this case, the adsorption treatment may be conducted after separating the hydrogenating catalyst after the completion of the nuclear hydrogenation reaction, or it is also possible to use a method in which an adsorbent is introduced into and mixed with the reaction solution without separating the hydrogenating catalyst, and solid-liquid separation of the catalyst and the adsorbent is carried out simultaneously. This method is advantageous because it is simple and easy to carry out and also has the effect of increasing the filtration rate.

As the adsorbent for the above-said treatment, there can be used, for instance, activated carbon, activated clay, ion exchange resins, synthetic adsorbents, and solid basic compounds such as magnesium oxide. Of these substances, the compounds containing magnesium oxide and activated carbon are preferred, with magnesium oxide being especially preferred.

The above adsorbing treatment may be conducted either according to a batch-wise contact system using a powdery adsorbent or a system in which the reaction product is passed through an adsorbent packing. The powdery adsorbent is preferably a powder having an average particle size of 1 to 1,000 μm. When using a granular adsorbent, it is preferable to use the grains having a size of 1 to 10 mm.

The amount of the adsorbent used is variable depending on the reaction conditions and the type of the adsorbent used, but it is usually 0.01 to 100% by weight, preferably 0.1 to 20% by weight, more preferably 0.2 to 10% by weight, based on the epoxy resin contained in the solution to be treated. When the adsorbent amount is less than 0.01% by weight, the intended effect of use of the adsorbent is not provided, and when the adsorbent is used in excess of 100% by weight, the loss of the product increases.

The adsorption treatment is carried out at a temperature of usually 0 to 100°C, preferably 10 to 80°C. As for the state of the adsorption treatment, it is preferably conducted in a state containing a solvent in view of workability, recovery rate and adsorption efficiency. The type of the solvent used is not specifically restricted; it is possible to use any type which is capable of dissolving the epoxy resins, but since the refining step by adsorption is usually conducted before the reaction solution is concentrated, preferably the reaction solvent is used as it is. The content of the solvent is usually 5 to 80% by weight, preferably 10 to 50% by weight, in terms of concentration in the solution to be treated. Use of the solvent in an insufficient amount causes an increase of viscosity of the solution to be treated, resulting in a reduced adsorption efficiency.

After the said after-treatment has been finished, the solvent is distilled away, usually at 50 to 220°C, preferably at 70 to 180°C, from the epoxy resin solution remaining after separation of the catalyst and adsorbent, and the resulting product is cooled and solidified to obtain a colorless and transparent solid hydrogenated epoxy resin.

Next, the alicyclic epoxy resins, namely the solid alicyclic epoxy resins (hydrogenated epoxy resins) according to the present invention are explained. The alicyclic epoxy resins according to the present invention are characterized in that they can meet the following requirements (a) to (d):

(a) epoxy equivalent is 500 to 10,000;
(b) nuclear hydrogenation rate is not lower than 96%;
(c) softening point as measured by the ring and ball method of JIS-K-7234 is 40 to 200°C: and
(d) light transmittance measured at a wavelength of 400 nm is not less than 90%.

The epoxy equivalent of the alicyclic epoxy resins according to the present invention preferably falls in the range of 550 to 10,000, more preferably 600 to 6,000, even more preferably 600 to 3,000. In the production of alicyclic

epoxy resins of the present invention through nuclear hydrogenation of aromatic epoxy resins such as mentioned above, the epoxy equivalent of the alicyclic epoxy resins is decided by the epoxy equivalent of the aromatic epoxy resin used as starting material and the rate of epoxy group decomposition that takes place as a side reaction in the course of nuclear hydrogenation. The epoxy equivalent preferably falls within the range of 600 to 10,000. The epoxy group decomposition rate is the rate at which the epoxy groups are decomposed into other functional groups such as hydroxyl groups, and it can be determined by calculations from the theoretical epoxy equivalent where the aromatic rings alone were hydrogenated and the actual epoxy equivalent of the product. The epoxy group decomposition rate of the produced alicyclic epoxy resin is preferably not more than 50%, more preferably not more than 30%, even more preferably not more than 20%. A high epoxy group decomposition rate tends to lead to a reduction of heat resistance of the cured product of this alicyclic epoxy resin.

The nuclear hydrogenation rate of the alicyclic epoxy resins according to the present invention is preferably not lower than 98% particularly in case where stability to light is required. The upper threshold of the nuclear hydrogenation rate is 100%. If the hydrogenation rate is less than 96%, when an epoxy resin composition of this invention is used for sealing LED of a nitride semiconductor, the composition absorbs light of short wavelengths to cause progressive resin deterioration with the lapse of time and resultant yellowing induces a sharp drop of emitted light luminance.

The softening temperature of the alicyclic epoxy resins according to the present invention is preferably 50 to 150°C, preferably 60 to 140°C. The alicyclic epoxy resins with higher softening temperature can be produced by using as starting material high-molecular weight aromatic epoxy resins with a larger epoxy equivalent. If the softening temperature is too low, the resin tends to become sticky and be easily fused to deteriorate the handling qualities of the resin. If the softening temperature is too high, a high temperature is required for melt mixing with a curing agent, etc., which leads to bad workability.

The color hue of the alicyclic epoxy resins according to the present invention is expressed by light transmittance. In the resins of the present invention, the light transmittance measured by a spectrophotometer at a wavelength of 400 nm using 1-cm long quartz cells with a solution prepared by dissolving 100 parts by mass of a hydrogenated epoxy resin in 200 parts by mass of an organic solvent such as ethyl acetate is not less than 90%.

As for the organic solvent used for the said measurement of light transmittance, any of those capable of dissolving the hydrogenated epoxy resins without substantially absorbing light can be used. It is also possible to use other types of solvent than ethyl acetate, for example, ester type solvents such as butyl acetate and ether type solvents such as tetrahydrofuran and dioxane.

If light transmittance of the obtained alicyclic epoxy resin is less than 90%, since the color hue of the resin is bad, it is impossible to obtain a colorless and transparent cured product, and the obtained product cannot be used as an optical material. The alicyclic epoxy resins obtainable by the present invention preferably show a high light transmittance when measured by using light in the near ultraviolet region. Specifically, their light transmittance at 340 nm is preferably not less than 80%, more preferably not less than 85%, even more preferably not less than 90%.

The total content of the alkaline metal elements and the Periodic Table group XV elements in the alicyclic epoxy resins obtainable by the present invention preferably is not more than 10 ppm. Such alicyclic epoxy resins are substantially free of basic substances, and when they are used, for instance, as an electric or electronic material, the impurities therein are minimized.

Also, the alicyclic epoxy resins obtainable by the present invention, when for instance obtained from the above-described nuclear hydrogenation of the aromatic epoxy resins, are lowered in melt viscosity and improved in fluidity as compared to the starting aromatic epoxy resins. When they are compared by melt viscosity at 150°C for instance, the melt viscosity of the produced alicyclic epoxy resins is usually not more than 70% of that of the starting aromatic epoxy resins.

The alicyclic epoxy resins obtainable according to the present invention are solid at normal temperature, highly transparent and useful as a base material for the various types of optical goods, coating compositions, etc. The alicyclic epoxy resins of the present invention can be produced, for instance, by the above-described methods of the present invention. It is preferable in particular that the alicyclic epoxy resins be produced by a method comprising nuclear hydrogenation of an aromatic epoxy resin whose epoxy equivalent is 500 to 10,000 and in which the total content of the alkaline metal elements and the Periodic Table group XV elements is not more than 10 ppm. It is also preferable that the said aromatic epoxy resin is a bisphenol A epoxy resin and/or bisphenol F epoxy resin, having an epoxy equivalent of 600 to 6,000. [Alicyclic epoxy resin compositions, epoxy resin cured product and uses of alicyclic epoxy resin compositions]

The alicyclic epoxy resin compositions according to the present invention comprise the said alicyclic epoxy resins and an epoxy resin curing agent.

(Epoxy resin curing agent)

The ordinary epoxy resin curing agents, such as those mentioned below, can be used as the epoxy resin curing

agent serving as component (B) of the compositions of the present invention.

(i) Amines: aliphatic and alicyclic amines such as bis(4-aminocyclohexyl)methane, bis(aminomethyl)cyclohexane, m-xylylenediamine and 3,9-bis(3-aminopropyl)-2,4,8,10-tetraspiro[5,5]undecane; aromatic amines such as methaphenilenediamine, diaminodiphenylmethane and diaminodiphenylsulfone; tertiary amines such as benzyldimethylamine, 2,4,6-tris(dimethylaminomethyl)phenol and 1,8-diazabicyclo-(5,4,0)-undecene-7,1,5-azabicyclo-(4,3,0)-nonene-7, and their salts.
(ii) Acid anhydrides: aromatic acid anhydrides such as phthalic anhydride, trimellitic anhydride and pyromellitic anhydride; and alicyclic acid anhydrides such as tetrahydrophthalic anhydride, methyltetrahydrophthalic anhydride, hexahydrophthalic anhydride, methylhexahydrophthalic anhydride, methyl endo methylenetetrahydrophthalic anhydride, dodecenylsuccinic anhydride and trialkyltetrahydrophthalic anhydride.
(iii) Polyhydric phenols: catechol, resorcin, hydroquinone, bisphenol F, bisphenol A, bisphenol S, biphenol, phenolic novolaks, cresol novolaks, novolak versions of dihydric phenols such as bisphenol A, trishydroxyphenylmethanes, aralkylpolyphenols, and dicyclopentadienepolyphenols.
(iv) Others: $BF_3$ complex compounds of amines; Brφnsted acid salts such as aliphatic sulfonium salts, aromatic sulfonium salts, iodonium salts and phosphonium salts; dicyandiamides; organic acid hydrazides such as adipic acid dihydrazide and phthalic acid dihydrazide; resols; polycarboxylic acids such as adipic acid, sebacic acid, terephthalic acid, trimellitic acid and carboxyl group-containing polyesters.

These epoxy resin curing agents may be used alone or as a combination of two or more.
The amount of the epoxy resin curing agent used in the composition, although variable depending on the type of the curing agent used, is usually in the range of 0.01 to 200 parts by mass, preferably 0.1 to 100 parts by mass, to 100 parts by mass of the hydrogenated epoxy resin.

(Acid anhydride compounds and cationic polymerization initiator)

In use of the epoxy resin compositions of the present invention particularly as a sealant for the luminous elements, it is preferable to use an acid anhydride compound or a cationic polymerization initiator as the epoxy resin curing agent in view of light resistance of the obtained epoxy resin composition. As such an acid anhydride compound, there can be used, for instance, aromatic acid anhydrides such as phthalic anhydride, trimellitic anhydride and pyromellitic anhydride, and alicyclic acid anhydrides such as tetrahydrophthalic anhydride, methyltetrahydrophthalic anhydride, hexahydrophthalic anhydride, methylhexahydrophthalic anhydride, methyl endo ethylenetetrahydrophthalic anhydride and trialkyltetrahydrophthalic anhydride. Of these acid anhydrides, the hydrogenated alicyclic acid anhydrides such as hexahydrophalic anhydride and methylhexahydrophthalic anhydride are especially preferred in view of improvement of light resistance of the obtained composition.
In case of using an acid anhydride compound, a curing accelerator may be introduced for the purpose of accelerating the curing. Examples of the curing accelerators usable for this purpose are tertiary amines, imidazoles, organic phosphine compounds or their salts, and metallic soaps such as zinc octylate and tin octylate.
The amount of the acid anhydride compound used as an epoxy resin curing agent is in the range of 5 to 200 parts by mass, especially 10 to 100 parts by mass, based on 100 parts by mass of the hydrogenated epoxy resin used as component (A). In case of introducing a curing accelerator, its amount is preferably selected to be 0.01 to 10 parts by mass based on 100 parts by mass of the hydrogenated epoxy resin.
As the cationic polymerization initiator, it is possible to use an activated energy ray cationic polymerization initiator which can generate a cation or a Lewis acid by the application of activated energy rays or a thermal cationic polymerization initiator which is capable of generating a cation or a Lewis acid by the application of heat.
As the active energy ray cationic polymerization initiator, there can be used, for instance: metallic fluoroboron complex salts and boron trifluoride complex compounds such as disclosed in U.S. Patent 3,379,653; bis(perfluoroalkylsulfonyl)methane metal salts such as disclosed in U.S. Patent 3,586,616; aryldiazonium compounds such as disclosed in U.S. Patent 3,708,296; aromatic onium salts of group VIa elements such as disclosed in U.S. Patent 4,058,400; aromatic onium salts of group Va elements such as disclosed in U.S. Patent 4,069,055; dicarbonyl chelates of groups IIIa-Va elements such as disclosed in U.S. Patent 4,068,091; thiopyrylium salts such as disclosed in U.S. Patent 4,139,655; group VIb elements in the form of MF6-anions (wherein M is selected from phosphorus, antimony and arsenic) such as disclosed in U.S. Patent 4,161,478; arylsulfonium complex salts such as disclosed in U.S. Patent 4,231,951; aromatic iodonium complex salts and aromatic sulfonium complex salts such as disclosed in U.S. Patent 4,256,828; and bis[4-(diphenylsulfonio)phenyl]sulfide-bis-hexafluoro metal salts (phosphates, arsenates, antimonates, etc.) such as disclosed in W. R. Watt et al: Journal of Polymer Science, Polymer Chemistry Edition, Vol. 22, page 1789 (1984)). These compounds may be used alone or in combination of two or more. It is also possible to use mixed ligand metal salts of iron compounds and silanol-aluminum complex.

Among the preferred active energy ray cationic polymerization initiators are arylsulfonium complex salts, aromatic sulfonium or iodonium salts of halogen-containing complex ions and aromatic onium salts of groups II, V and VI elements. Some of these salts are commercially available under the trade names of "FX-512" (3M Company), "UVR-6990" and "UVR-6974" (Union Carbide Corporation), "UVE-1014" and "UVE-1016" (General Electric Company), "KI-85" (Degussa), "SP-150" and "SP-170" (Asahi Denka Co., Ltd.), and "San-Aid SI-60L", "San-Aid SI-801" and "San-Aid SI-100L" (SANSHIN CHEMICAL INDUSTRY CO., LTD.).

As the thermal cationic polymerization initiator, the cationic type compounds such as triflic acid salts, boron trifluoride ether complex compounds, boron trifluoride, etc., and protonic acid catalysts can be mentioned. Triflic acid salts are preferred, the examples thereof including diethylammonium triflate available as "FC-520" from 3M Company, triethylammonium triflate, diisopropylammonium triflate and ethyldiisopropylammonium triflate (many of them are described in R.R. Alm: Modern Coatings, published in October, 1980). Of the above-mentioned aromatic onium salts usable as an active energy ray cationic polymerization initiator, those which generate a cationic seed by heat can be also used as a thermal cationic polymerization initiator. Examples thereof are "San-Aid SI-60L", "San-Aid SI-80L" and "San-Aid SI-100L" (SANSHIN CHEMICAL INDUSTRY CO., LTD.).

Among these active energy ray and thermal cationic polymerization initiators, the onium salts are preferred because of ease of handling and a good balance of potency and curing properties. In such onium salts, diazonium salt, iodonium salt, sulfonium salt and phosphonium salt are especially preferred for a good balance of handling characteristics and potency.

A cationic polymerization initiator is used in an amount of preferably 0.01 to 15 parts by weight, more preferably 0.05 to 5 parts by weight, based on 100 parts by weight of the hydrogenated epoxy resin used as component (A).

No matter whichever type of epoxy resin curing agent is used, if its amount used is outside the specified range, the balance of heat resistance and moisture resistance of the epoxy resin cured product will deteriorate.

(Antioxidant)

In the epoxy resin compositions of the present invention, particularly one used as a sealant for the luminous elements, it is preferred to incorporate an antioxidant to prevent oxidative degradation in heating for obtaining a cured product with minimized tinting.

The antioxidants usable here include phenolic, sulfur type and phosphorus type ones, and such an antioxidant is used in an amount of usually 0.005 to 5 parts by mass, preferably 0.01 to 1 part by mass, based on 100 parts by mass of the hydrogenated epoxy resin which is component (A). Examples of the antioxidants usable for the above purpose include the following.

[Phenolic antioxidants]

Monophenols: 2,6-di-t-butyl-p-cresol, butylated hydroxyanisole, 2,6-t-butyl-p-ethylphenol, stearyl-β-(3,5-di-t-butyl-4-hydroxyphenyl) propionate, etc. Bisphenols: 2,2'-methylenebis(4-methyl-6-t-butylphenol), 2,2'-methylenebis(4-ethyl-6-t-butylphenol), 4,4'-thiobis(3-methyl-6-t-butylphenol), 4,4'-butylidenebis(3-methyl-6-t-butylphenol), 3,9-bis[1,1-dimethyl-2-(P-(3-t-butyl-4-hydroxy-5-methylphenyl)propionyloxy}ethyl]-2,4,8,10-tetraoxaspiro[5,5]undecane, etc. High-molecular phenols: 1,1,3-tris(2-methyl-4-hydroxy-5-t-butylphenyl)butane, 1,3,5-trimethyl-2,4,6-tris(3,5-di-t-butyl-4-hydroxybenzyl)-benzene, tetrakis-[methylene-3-(3',5'-di-t-butyl-4'-hydroxyphenyl)propionate]methane, bis[3,3'-bis-(4'-hydroxy-3'-t-butylphenyl)butylic acid] glycol ester, 1,3,5-tris(3',5'-di-t-butyl-4'-hydroxybenzyl)-S-triazine-2,4,6-(1H,3H,5H) trion, tocophenol, etc.

[Sulfur type antioxidants]

Dilauryl-3,3'-thiodipropionate, dimyristyl-3,3'-thiodipropionate, distearyl-3,3'-thiodipropionate, etc.

[Phosphorus type antioxidants]

Phosphites: triphenyl phosphite, diphenylisodecyl phosphite, phenyldiisodecyl phosphite, tris(nonylphenyl) phosphite, diisodecylpentaerythritol phosphite, tris(2,4-di-t-butylphenyl) phosphite, cyclic neopentanetetrailbis(octadecyl) phosphite, cyclic neopentanetetrailbis(2,4-di-t-butylphenyl) phosphite, cyclic neopentanetetrailbis(2,4-di-t-butyl-4-methylphenyl) phosphite, bis[2-t-butyl-6-methyl-4-{2-(octadecyloxycarbonyl)ethyl}phenyl]hydrogen phosphite, etc. Oxaphosphaphenanthrene oxides: 9,10-dihydro-9-oxa-10-phosphaphenanthrene-10-oxide, 10-(3,5-di-t-butyl-4-hydroxybenzyl)-9,10-dihydro-9-oxa-10-phosphaphenanthrene-10-oxides, 10-desiloxy-9,10-dihydro-9-oxa-10-phosphatharene-10-oxide, etc.

These antioxidants may be used singly, but it is particularly preferable to use them in combination of two or

more, such as combination of phenolic/sulfur type or phenolic/phosphorus type.

(Optional components)

In the epoxy resin compositions of the present invention, the following substances may be incorporated as optional components.

(1) Other epoxy resins: for instance alicyclic epoxy resins such as 3,4-epoxycyclohexylmethyl-3',4'-epoxycyclohexane carboxylate, solid alicyclic epoxy resins such as EHPE3150 (trade name by Daicel Chemical Industries, Ltd.), and polyfunctional heterocyclic epoxy resins such as triglycidyl isocyanurate.
(2) Powdery reinforcements and fillers: for instance metal oxides such as aluminum oxide and magnesium oxide; silicon compounds such as finely powdered silica, molten silica and crystalline silica; transparent fillers such as glass beads; metal hydroxides such as aluminum hydroxide; kaolin, mica, quartz powder, graphite, molybdenum disulfide, etc.
The above substances (1) and (2) are incorporated in an amount which won't affect transparency of the epoxy resin composition of the present invention. It is appropriate to add them each in an amount of not more than 100 parts by mass, for instance 10 to 100 parts by mass, based on 100 parts by mass of the hydrogenated epoxy resin forming component (A) of the composition.
(3) Colorants or pigments: for instance titanium dioxide, molybdenum red, Prussian blue, ultramarine, cadmium yellow, cadmium red and organic pigments.
(4) Flame retardants: for instance antimony trioxide, bromine compounds and phosphorus compounds.
(5) Additives such as ultraviolet absorber, ion adsorbate, coupling agent, releasing agent, etc.

In case where the above substances (3) to (5) are incorporated, they are added each in an amount of not more than 30 parts by mass, for example 0.01 to 30 parts by mass, based on 100 parts by mass of the hydrogenated epoxy resin of component (A).
Further, in the epoxy resin compositions of the present invention, various types of curable monomers, oligomers and synthetic resins other than epoxy resins can be incorporated for the purpose of improving properties of the epoxy cured product. For instance, one or a combination of two or more of diols, triols, vinyl ethers, oxetane compounds, fluorine resins, acrylic resins, silicone resins and the like can be added. The amount of these compounds and resins to be incorporated should be in the range where they have no possibility of affecting the normal properties of the epoxy resin compositions of the present invention. For instance, they are added in an amount of preferably not more than 50 parts by mass based on 100 parts by mass of the hydrogenated epoxy resin of component (A).

(Epoxy resin cured product)

The method for curing the epoxy resin compositions of the present invention is not specifically defined. For instance, it is possible to obtain an epoxy resin cured product (cured epoxy resin) by subjecting a mixture of an epoxy resin, an epoxy resin curing agent and other optional components to a curing reaction by use of light or heat. The epoxy resin cured product of the present invention has high toughness and is very low in content of impurities such as hydrolyzable chlorine and basic compounds, so that it is suited for use as a material, such as insulating material, for electric and electronic parts. Particularly, because of its excellent transparency and light resistance, the epoxy resin cured product of the present invention can be used especially advantageously for sealing of the luminous elements described below.

(Luminous elements and semiconductor light-emitting devices)

The epoxy resin compositions according to the present invention, particularly for their excellent light resistance, are useful for sealing of the luminous elements which emit light of a relatively short wavelength, with a peak wavelength of 350 to 550 nm, and are capable of providing the excellent semiconductor light-emitting devices.
Such luminous elements are, for instance, those formed by using the group III nitride system compound semiconductors formed by a metalorganic chemical vapor deposition method (MOCVD method), a molecular beam epitaxy method (MBE method) or a halide vapor phase epitaxy method (HVPE method), which semiconductors are represented by a general formula of $Al_xGa_yIn_{1-x-y}N$ ($0 \leqq x \leqq 1$, $0 \leqq y \leqq 1$, $0 \leqq x+y \leqq 1$) and comprehend the so-called two-component system of $Al_x$, GaN and InN and the so-called three-component system of $Al_xGa_{1-x}N$, $Al_xIn_{1-x}N$ and $Ga_xIn_{1-x}N$ ($0 \leqq x \leqq 1$) in the above formulae). The semiconductor structures include homo structure, hetero structure and double-hetero structure, having MIS junction, PIN junction or pn junction. The emitted light wavelength can be selected from a wide range according to the material of the semiconductor layer and its degree of crystal mixing. It is also possible to adopt a single-quantum or multiple quantum well structure in which the semiconductor layer is formed as a thin film which produces a quantum effect.

(Method of producing solid sealants)

The luminous element sealants using the epoxy resin compositions according to the present invention are preferably solid at normal temperature. They can be produced, for instance, by a method in which a solid hydrogenated epoxy resin, an epoxy resin curing agent and optional components such as mentioned above are melted by heating and uniformly mixed by a mixer, blender, roll mill or like means, or a preliminary reaction of the hydrogenated epoxy resin and the epoxy resin curing agent is carried out while adjusting the work to have a softening temperature in the range of 40 to 150°C, preferably 50 to 130°C, and then the mixture is cooled and solidified and finally pulverized to obtain a powdery luminous element sealant. If desired, the obtained powdery product may be compressed into tablets.

If the softening temperature of the sealant is below 40°C, this sealant cannot be treated as a solid and is incapable of transfer molding. It is therefore preferable to carry out a preliminary reaction of the hydrogenated epoxy resin and the epoxy resin curing agent as required and to raise the softening temperature of the sealant to 40°C or higher. It should be also noted, however, that if the softening temperature exceeds 150°C, the melting temperature of the product becomes too high to carry out transfer molding.

(Luminous element sealing method)

For sealing a luminous element with the sealants according to the present invention, a method using a known low-pressure transfer molding machine is preferred, with sealing of the element being preferably carried out under the molding conditions of 100 to 200°C and 0.1 to 20 minutes. Further, in order to improve sealant performance after molding, it is preferable to conduct postcuring at a temperature of 70 to 170°C for a period of 0.1 to 10 hours.

## EXAMPLES

The present invention will be described in more detail by showing the examples and the comparative examples, but it should be understood that the present invention is not restricted by these examples but can be embodied otherwise without departing from the scope and spirit of the invention. The analytical methods and the methods used for the determination of properties are as described below.

(1) Hydrogenation rate of aromatic rings of alicyclic epoxy resins

Using the samples dissolved in ethyl acetate, absorbance at a wavelength of 275 nm of each sample was measured and compared with that of the starting aromatic epoxy resin. The degree of dilution by ethyl acetate was varied in the range of 10 to 1,000 times according to the nuclear hydrogenation rate.

(2) Epoxy equivalent

According to JIS-K7236-1995, the sample solution was titrated with perchloric acid in the presence of acetic acid and cetyltrimethylammonium bromide, the generated hydrogen bromide was added to the epoxy groups, and the end point of titration was judged from the potential difference.

(3) Epoxy group decomposition rate

This was calculated by the following method.

(i) In the case of bisphenol A epoxy resin, it is supposed to be represented by the following molecular formula, with the average molecular weight being assumed to be 340 + 284n.

[Chemical formula 1]

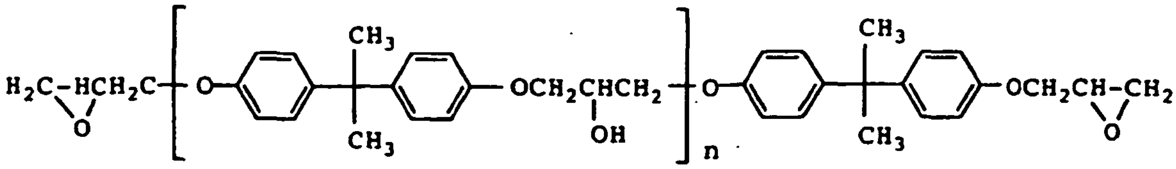

(ii) n is determined from the epoxy equivalent WR of the starting epoxy resin according to the following equation:

[Formula 1]

$$WR = (340 + 284n)/2$$

Hence, n = (2 x WR - 340)/284

(iii) The molecular formula when the epoxy groups were hydrogenated ideally with no decomposition is given as follows, and the ideal epoxy equivalent WC is calculated from n:

[Formula 2]

$$WC = (352 + 296n)/2$$

[Chemical formula 2]

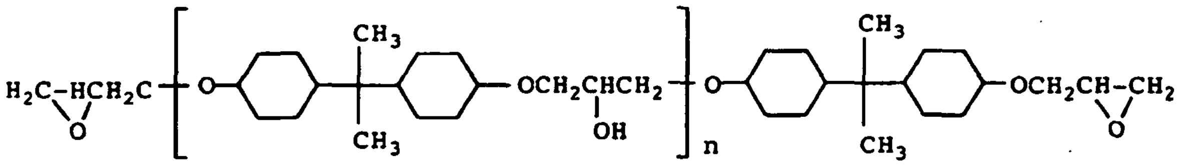

(iv) The decomposition rate is calculated from the epoxy equivalent WP of the actually obtained epoxy resin and its ideal value WC according to the following equation:

$$\text{Decomposition rate (\%)} = (1 - WC/WP) \times 100$$

(4) Light transmittance

The epoxy resin was dissolved in twice as much ethyl acetate by weight, and light transmittance of this solution was determined by measuring transmittance of light of wavelengths of 400 nm and 340 nm by a spectrophotometer UV-2400PC (Shimadzu Corporation) using the 1 cm cells, with ethyl acetate as blank.

(5) Softening temperature

Determined by the ring and ball method (JIS-K7234-1986).

(6) Melt viscosity

Melt viscosity at 150°C was measured by an ICI viscometer (cone-and-plate rotational viscometer).

(7) Glass transition temperature Tg (°C)

Determined by the TMA method (rate of temperature rise: 5°C /min).

(8) Thermal shock resistance (crack resistance)

Three sample pieces of epoxy resin cured product having an Oliphant washer embedded therein were subjected to a thermal shock test with cycles between 170°C and -75°C shown in Table 1 below. The test was stopped when the cured product cracked, and "crack resistance" at the crack-developed cycle was shown by a mean value.

Table 1

| Number of cycles | State of the test piece | Test time (min) | Crack resistance |
|---|---|---|---|
| 1 | As is | - | 0 |
| 2 | Cooled from 25°C to 5°C | 10 | 1 |
| 3 | Heated from 5°C to 25°C | 30 | 2 |
| 4 | Cooled from 25°C to -15°C | 10 | 3 |
| 5 | Heated from -15°C to 25°C | 30 | 4 |
| 6 | Cooled from 25°C to -35°C | 10 | 5 |
| 7 | Heated from -35°C to 25°C | 30 | 6 |
| 8 | Cooled from 25°C to -55°C | 10 | 7 |
| 9 | Heated from -55°C to 25°C | 30 | 8 |
| 10 | Heated from 25°C to 130°C | 30 | 9 |
| 11 | Cooled from 130°C to -55°C | 10 | 10 |
| 12 | Heated from -55°C to 150°C | 30 | 11 |
| 13 | Cooled from 150°C to -75°C | 10 | 12 |
| 14 | Heated from -75°C to 170°C | 30 | 13 |
| 15 | Cooled from 170°C to -75°C | 10 | 14 |
| 16 | Heated from -75°C to 25°C | 30 | 15 |
| 17 | Passed through all cycles | - | 16 |

(9) Ultraviolet light resistance

Using a Metaling Weather Meter (mfd. by Suga Test Instruments Co., Ltd.), ultraviolet rays were applied to the epoxy resin cured product at an irradiation intensity of 0.4 $kW/m^2$ and a black panel temperature of 63°C for 72 hours, and the YI value (yellowness index) of the cured product was measured.

(10) Resistance to heat deterioration

The YI value (yellowness index) of the epoxy resin cured product after 72-hour heating at 150°C was measured.

(11) Moisture absorption rate (%)

The moisture absorption rate of a 3 mm thick and 50 mm diameter disc-shaped epoxy resin cured product after left at 121°C for 24 hours was measured. Production Example 1 (Preparation of hydrogenation catalyst)

625 mg of 40 wt% rhodium chloride (produced by N.E. Chemcat Corporation) was dissolved in 20 g of water, and 4.75g of commercial graphite (HSAG100 produced by TIMCAL, specific surface area: 130 $m^2/g$) was added into and impregnated with the resulting aqueous solution of rhodium chloride. Then an aqueous solution of 0.78 g of 28 wt% ammonia water in 6 ml of water was added to carry out a fixation treatment at room temperature. The resulting solid product was filtered out, washed well with ion exchange water and dried at 50°C to obtain a non-reduced rhodium/graphite catalyst supporting 5% by weight of rhodium.

[Examples 1 to 5 and Comparative Examples 1 to 4: Relating to alicyclic epoxy resins]

Example 1

200 g of a bisphenol A solid epoxy resin (Epikote 1002 produced by Japan Epoxy Resins Co., Ltd.; epoxy equivalent: 642; contents of Li, Na, K, N and P: each being not more than 1 ppm, with the total content being not more than 5 ppm; light transmittance at 400 nm: 96%; light transmittance at 340 nm: 69%; melt viscosity: 1,400 mPa·s; one-stage process product), 200 g of ethyl acetate and 0.4 g of the non-reduced 5 wt% rhodium/graphite catalyst obtained in Production Example 1 (ratio to epoxy resin: 0.2% by weight, and ratio to epoxy resin as rhodium: 0.01% by weight) used as hydrogenation catalyst, were supplied into a one-litre induction stirring type autoclave, and the atmosphere in the autoclave was replaced with nitrogen and then with hydrogen. Thereafter, the mixture was subjected to a 6-hour hydrogenation reaction under a hydrogen pressure of 8 MPa at 110°C. (Absorption of hydrogen was monitored by a pressure accumulator, and the reaction was ended when the absorption of hydrogen substantially ceased.)
After the end of the reaction, the reaction solution was diluted with ethyl acetate, to which 4 g of magnesium oxide (Kyowamag 150) produced by Kyowa Chemical Industry Co., Ltd.) was added, and the solution was stirred and mixed for 30 minutes at room temperature and then filtered. After filtration, ethyl acetate in the reaction solution was recovered by distillation, and after removing the solvent under a pressure of 100 MPa at 160°C, the solution was discharged out and cooled to obtain a colorless and transparent hydrogenated epoxy resin (alicyclic epoxy resin).
The obtained hydrogenated epoxy resin was a colorless and transparent solid and had a nuclear hydrogenation rate of 99.4%, an epoxy equivalent of 719, an epoxy group decomposition rate of 7%, a light transmittance at 400 nm of 99%, a light transmittance at 340 nm of 96%, a softening temperature of 71°C and a melt viscosity of 860 mPa·s.

Example 2

200 g of a bisphenol A solid epoxy resin (Epikote 1003 produced by Japan Epoxy Resins Co., Ltd.; epoxy equivalent: 741; contents of Li, Na, K, N and P: each being not more than 1 ppm, with the total content being not more than 5 ppm; light transmittance at 400 nm: 96%; light transmittance at 340 nm: 65%; melt viscosity: 2,700 mPa·s; one-stage process product), 200 g of ethyl acetate and 1 g of the non-reduced 5 wt% rhodium/graphite catalyst obtained in Production Example 1 (ratio to epoxy resin: 0.5% by weight, ratio to epoxy resin as rhodium: 0.025% by weight) used as hydrogenation catalyst, were supplied to an autoclave, and the atmosphere in the autoclave was replaced with nitrogen and then with hydrogen. Then the mixture was subjected to a hydrogenation reaction at 110°C under a hydrogen pressure of 8 MPa for 1.8 hours, and thereafter the same operations as conducted in Example 1 were repeated to obtain a hydrogenated epoxy resin (alicyclic epoxy resin).
The obtained hydrogenated epoxy resin was a colorless and transparent solid and had a nuclear hydrogenation rate of 99.8%, an epoxy equivalent of 909, an epoxy group decomposition rate of 15%, a light transmittance at 400 nm of 99%, a light transmittance at 340 nm of 96%, a softening temperature of 72°C and a melt viscosity of 1,540 mPa·s.

Example 3

200 g of a bisphenol A solid epoxy resin (Epikote 1004AF produced by Japan Epoxy Resins Co., Ltd.; epoxy equivalent: 919; contents of Li, Na, K, N and P: each being not more than 1 ppm, with the total content being not more than 5 ppm; light transmittance at 400 nm: 95%; light transmittance at 340 nm: 66%; melt viscosity: 6,900 mPa·s; one-stage process product), 200 g of ethyl acetate and 1 g of the non-reduced 5 wt% rhodium/graphite catalyst produced in Production Example 1 (ratio to epoxy resin: 0.5% by weight, ratio to epoxy resin as rhodium: 0.025% by weight) as a hydrogenation catalyst were supplied to an autoclave and the atmosphere in the autoclave was replaced with nitrogen and then with hydrogen. Then the mixture was subjected to a hydrogenation reaction at 110°C under a hydrogen pressure of 8 MPa for 2 hours, and thereafter the same operations as conducted in Example 1 were repeated to obtain a hydrogenated epoxy resin (alicyclic epoxy resin).
The obtained hydrogenated epoxy resin was a colorless and transparent solid and had a nuclear hydrogenation rate of 99.9%, an epoxy equivalent of 1,184, an epoxy group decomposition rate of 19%, a light transmittance at 400 nm of 99%, a light transmittance at 340 nm of 96%, a softening temperature of 85°C and a melt viscosity of 3,200 mPa·s.

Example 4

100 g of a bisphenol A solid epoxy resin (Epikote 1007 produced by Japan Epoxy Resins Co., Ltd.; epoxy equivalent: 2,015; contents of Li, Na, K, N and P: each being not more than 1 ppm, with the total content being not more than 5 ppm; light transmittance at 400 nm: 90%; light transmittance at 340 nm: 65%; melt viscosity: 40,000 mPa·s; one-stage process product), 300 g of ethyl acetate and 2 g of the non-reduced 5 wt% rhodium/graphite catalyst produced in Production Example 1 (ratio to epoxy resin: 2% by weight, and ratio to epoxy resin as rhodium: 0.1% by weight) used as a hydrogenation catalyst were supplied to an autoclave, and the atmosphere in the autoclave was replaced with nitrogen and then with hydrogen. Then the mixture was subjected to a hydrogenation reaction at 110°C under a hydrogen pressure of 8 MPa for one hour, and thereafter the same operations as conducted in Example 1 were repeated except for use of MgO (AD100P produced by Tomita Pharmaceutaical Co., Ltd.) as adsorbent to obtain a hydrogenated epoxy resin (alicyclic epoxy resin).
The obtained epoxy resin was a colorless and transparent solid and had a nuclear hydrogenation rate of 99.2%, an epoxy equivalent of 2,199, an epoxy group decomposition rate of 5%, a light transmittance at 400 nm of 92%, a light transmittance at 340 nm of 85%, a softening temperature of 101°C and a melt viscosity of 14,700 mPa·s.

Example 5

300 g of a bisphenol F solid epoxy resin (Epikote 4004P produced by Japan Epoxy Resins Co., Ltd.) was dissolved in 1,200 g of methyl isobutyl ketone and washed thrice with 500 g of purified water at 70 to 80°C. Then methyl isobutyl ketone was distilled away to obtain 200 g of an epoxy resin (epoxy equivalent: 878; contents of Li, Na, K, N and P: each being not more than 1 ppm, with the total content being not more than 5 ppm). This 200 g of the epoxy resin, 200 g of ethyl acetate and 1 g of the non-reduced 5 wt% rhodium/graphite catalyst obtained in Production Example 1 (ratio to epoxy resin: 2% by weight and ratio to epoxy resin as rhodium: 0.1% by weight) as a hydrogenation catalyst were supplied to an autoclave and the atmosphere in the autoclave was replaced with nitrogen and then with hydrogen. Then the mixture was subjected to a hydrogenation reaction at 110°C under a hydrogen pressure of 8 MPa for 2 hours, and thereafter the same operations as conducted in Example 1 were repeated to obtain a hydrogenated epoxy resin (alicyclic epoxy resin).
The obtained hydrogenated epoxy resin was a colorless and transparent solid and had a nuclear hydrogenation rate of 99.8%, an epoxy equivalent of 1,022 and a softening temperature of 74°C.

Comparative Example 1

The same reaction operations as conducted in Example 3 were carried out except that Epikote 1004F produced by Japan Epoxy Resins Co., Ltd. (epoxy equivalent: 933; N content: 18 ppm; two-stage process product) was used as the bisphenol A solid epoxy resin. Since no consumption of hydrogen took place in one hour of reaction, the reaction was stopped.

Comparative Example 2

The same reaction operations as conducted in Example 4 were carried out except for use of Epikote 1006F produced by Japan Epoxy Resins Co., Ltd. (epoxy equivalent: 1,103; N content: 17 ppm; two-stage process product) as the epoxy resin. Since no consumption of hydrogen took place in one hour of reaction, the reaction was stopped.

Comparative Example 3

The same reaction operations as conducted in Example 4 were carried out except for use of Epikote 1006FS produced by Japan Epoxy Resins Co., Ltd. (epoxy equivalent: 965; Na content: 20 ppm; two-stage process product) as the epoxy resin. Since no consumption of hydrogen took place in one hour of reaction, the reaction was stopped.

Comparative Example 4

A hydrogenated epoxy resin was obtained by carrying out the same hydrogenation reaction and after-treatment operations as conducted in Production Example 1 except for use of Epikote 1001 produced by Japan Epoxy Resins Co., Ltd. (epoxy equivalent: 465; contents of Li, Na, K, N and P: each being not more than 1 ppm, with the total content being not more than 5 ppm) as the bisphenol A solid epoxy resin.
The obtained hydrogenated epoxy resin was a colorless and transparent viscous liquid and had a nuclear hydrogenation rate of 99.8%, an epoxy equivalent of 534 and a light transmittance of 99%.

The above results show that according to the present invention it is possible to obtain an alicyclic epoxy resin with high transparency, which is solid at normal temperature, by carrying out nuclear hydrogenation of an aromatic epoxy resin at a high hydrogenation rate.

[Examples 6 to 11 and Comparative Examples 5 and 6: Relating to epoxy resin compositions]

Example 6

100 parts of the solid hydrogenated epoxy resin obtained in Example 1, 23 parts of Rikacid MH-700 (trade name of methylhexahydrophthalic anhydride produced by New Japan Chemical CO., LTD.) used as a curing agent, 1 part of Hishicolin PX-4ET (trade name of tetra-n-butylphosphonium-o,o-diethylphosphorodithionate produced by Nippon Chemical Industrial CO., LTD.) used as a curing accelerator, 0.2 part of 2,6-di-tert-butyl-p-cresol used as an antioxidant and 0.2 part of diphenylisodecyl phosphite were mixed by a mixing mill and subjected to a preliminary reaction while carrying out melt mixing at 80 to 90°C for 20 minutes to prepare a half-cured (B-stage) epoxy resin composition. The softening temperature (measured by the ring and ball method of JIS-K-7234) and gelation time (measured by the steel plate method at 150°C) of this epoxy resin composition were as shown in Table 2. The produced molten epoxy resin composition was drawn out as a sheet and crushed to obtain a molding material. In Table 2, "Epoxy resins I" indicate the hydrogenated epoxy resins according to the present invention and "Epoxy resins II" indicate other epoxy resins.

The thus obtained molding material was molded into the test pieces by a low-pressure transfer molding machine, with the molding being conducted at a mold temperature of 150°C for 180 seconds, and these test pieces were postcured at 140°C for 3 hours to obtain the colorless and transparent cured products. The results of evaluation of these cured products are shown in Table 2.

Examples 7 to 11 and Comparative Examples 5 and 6

The same procedure as defined in Example 6 was conducted except for the changes of the epoxy resin and the epoxy resin curing agent as shown in Table 2 to prepare the epoxy resin compositions having the softening temperatures (measured by the ring and ball method of JIS-K-7234) and the gelation times (measured by the steel plate method at 150°C) shown in Table 2, and the cured products were similarly obtained from these epoxy resin compositions. (Since the epoxy resin composition of Comparative Example 1 was liquid, it was incapable of molding and curing). The evaluation results of the cured products are shown in Table 2.

Table 2

| | Example | | | |
|---|---|---|---|---|
| | 6 | 7 | 8 | 9 |
| Formulation of epoxy resin compositions (parts)(*1) | | | | |
| Epoxy resins I<br>Example<br>Amount blended | <br>1<br>100 | <br>2<br>100 | <br>3<br>100 | <br>4<br>80 |
| Epoxy resins II (*2)<br>Type<br>Amount blended | <br>-<br>- | <br>-<br>- | <br>-<br>- | <br>A<br>20 |
| Curing agent<br>MH-700<br>CI-2624 (*3) | <br>23<br>- | <br>18<br>- | <br>14<br>- | <br>25<br>- |
| Curing accelerator (PT-4ET) | 1 | 1 | 1 | 1 |
| Properties of epoxy resin compositions | | | | |
| ·Softening temperature (°C) | 50 | 55 | 70 | 80 |
| ·Gelation time (sec) | 110 | 80 | 65 | 60 |
| Evaluation results of cured products | | | | |
| ·Glass transition temperature Tg (°C) | 104 | 96 | 94 | 105 |
| Thermal shock resistance | 10 | 12 | 12 | 10 |
| Ultraviolet light resistance | 6 | 7 | 5 | 6 |
| Resistance to thermal deterioration | 7 | 7 | 5 | 4 |
| Moisture absorption (%) | 0.8 | 0.7 | 0.7 | 0.9 |

*1: Formulation ingredients other than antioxidant.

*2: Epoxy resin A = solid alicyclic epoxy resin (EHPE3150 produced by Daicel Chemical Industries, Ltd.)

Epoxy resin B = 3,4-epoxycyclohexylmethyl-3',4'-epoxycyclohexane carboxylate (produced by Japan Epoxy Resins Co., Ltd.)

Epoxy resin C = bisphenol A solid epoxy resin (E1004AF produced by Japan Epoxy Resins Co., Ltd.)

*3: Aromatic sulfonium salt type cationic polymerization initiator (produced by Nippon Soda CO., LTD.)

Table 2 (Continued)

| | Example | | Comp. Example | |
|---|---|---|---|---|
| | 10 | 11 | 1 | 2 |
| Formulation of epoxy resin compositions (parts)(*1) | | | | |
| Epoxy resins I<br>Example<br>Amount blended | <br>5<br>100 | <br>3<br>80 | <br>-<br>- | <br>-<br>- |
| Epoxy resins II (*2)<br>Type<br>Amount blended | <br>-<br>- | <br>B<br>20 | <br>Comp. Ex. 4<br>100 | <br>C<br>100 |
| Curing agent<br>MH-700<br>CI-2624 (*3) | <br>16<br>- | <br>-<br>1 | <br>31<br>- | <br>18<br>- |
| Curing accelerator (PT-4ET) | 1 | - | 1 | 1 |
| Properties of epoxy resin compositions | | | | |
| ·Softening temperature (°C) | 55 | 60 | Liquid | 75 |
| ·Gelation time (sec) | 80 | 60 | 210 | 60 |
| Evaluation results of cured products | | | | |
| ·Glass transition temperature Tg (°C) | 91 | 98 | *4) | 120 |
| Thermal shock resistance | 12 | 7 | *4) | 8 |
| Ultraviolet light resistance | 5 | 10 | *4) | 26 |
| Resistance to thermal deterioration | 7 | 9 | *4) | 5 |
| Moisture absorption (%) | 0.7 | 0.9 | *4) | 1.0 |

*1: Formulation ingredients other than antioxidant.

*2: Epoxy resin A = solid alicyclic epoxy resin (EHPE3150 produced by Daicel Chemical Industries, Ltd.)

Epoxy resin B = 3,4-epoxycyclohexylmethyl-3',4'-epoxycyclohexane carboxylate (produced by Japan Epoxy Resins Co., Ltd.)

Epoxy resin C = bisphenol A solid epoxy resin (E1004AF produced by Japan Epoxy Resins Co., Ltd.)

*3: Aromatic sulfonium salt type cationic polymerization initiator (produced by Nippon Soda CO., LTD).

*4: Incapable of molding because of being liquid.

As seen from Table 2, according to the present invention, it is possible to obtain an epoxy resin cured product which is colorless and transparent and has excellent thermal shock resistance, light resistance and heat resistance.

## Claims

1. A process for producing an alicyclic epoxy resin which comprises nuclear hydrogenation of an aromatic epoxy resin in the presence of a catalyst containing a platinum group element, wherein
said aromatic epoxy resin has an epoxy equivalent of from 500 to 10,000 and a total content of alkaline metals and group XV elements of not more than 10 ppm, and
said catalyst containing a platinum group element is offered to the reaction as a catalyst precursor in a non-reduced state, prepared by supporting a platinum group element compound on a carrier.

2. The process for producing an alicyclic epoxy resin according to claim 1, wherein the aromatic epoxy resin is a bisphenol A epoxy resin and/or a bisphenol F epoxy resin, with an epoxy equivalent of 600 to 6,000.

3. The process for producing an alicyclic epoxy resin according to claim 1 or 2, wherein when reducing the catalyst precursor, an aromatic epoxy resin is allowed to coexist so that reduction of the catalyst precursor and nuclear hydrogenation reaction of the aromatic epoxy resin are carried out in parallel with each other in the same reaction system.

## Patentansprüche

1. Verfahren zur Herstellung eines alicyclischen Epoxyharzes, welches Kernhydrierung eines aromatischen Epoxyharzes in Gegenwart eines Platingruppenelementhaltigen Katalysators umfasst, worin
das aromatische Epoxyharz ein Epoxyäquivalent von 500 bis 10.000 und einen Gesamtgehalt von Alkalimetallen und Gruppe-XV-Elementen von nicht mehr als 10 ppm aufweist und
der Platingruppenelement-haltige Katalysator der Reaktion als Katalysatorvorläufer in einem nichtreduzierten Zustand zur Verfügung gestellt wird, der durch Tragen einer Platingruppenelementverbindung auf einen Träger hergestellt ist.

2. Verfahren zur Herstellung eines alicyclischen Epoxyharzes gemäß Anspruch 1, worin das aromatische Epoxyharz ein Bisphenol A-Epoxyharz und/oder ein Bisphenol F-Epoxyharz mit einem Epoxyäquivalent von 600 bis 6.000 ist.

3. Verfahren zur Herstellung eines alicyclischen Epoxyharzes gemäß Anspruch 1 oder 2, wobei ein aromatisches Epoxyharz koexistiert, wenn der Katalysatorvorläufer reduziert wird, so dass die Reduktion des Katalysatorvorläufers und die Kernhydrierungsreaktion des aromatischen Epoxyharzes parallel im selben Reaktionssystem durchgeführt werden.

## Revendications

1. Procédé de production d'une résine époxy alicyclique qui comprend l'hydrogénation nucléaire d'une résine époxy aromatique en présence d'un catalyseur contenant un élément du groupe du platine, où
ladite résine époxy aromatique possède un équivalent époxy de 500 à 10 000 et une teneur totale en métaux alcalins et éléments du groupe XV non supérieure à 10 ppm, et
ledit catalyseur contenant un élément du groupe du platine est soumis à la réaction en tant qu'un précurseur catalytique dans un état non réduit, préparé en faisant supporter un composé élément du groupe du platine sur un support.

2. Procédé de production d'une résine époxy alicyclique selon la revendication 1, où la résine époxy aromatique est une résine époxy de bisphénol A et/ou une résine époxy de bisphénol F, avec un équivalent époxy de 600 à 6000.

3. Procédé de production d'une résine époxy alicyclique selon la revendication 1 ou 2, où lors de la réduction du précurseur catalytique, on laisse coexister une résine époxy aromatique de sorte que la réduction du précurseur catalytique et la réaction d'hydrogénation nucléaire de la résine époxy aromatique sont réalisées en parallèle l'une de l'autre dans le même système réactionnel.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 3336241 A
- JP 10204002 A
- JP 11217379 A
- JP 11199645 A
- JP 2003081957 A
- EP 545154 A1
- JP 9213997 A
- JP 2000196151 A
- JP 2003012896 A
- US 3379653 A
- US 3586616 A
- US 3708296 A
- US 4058400 A
- US 4069055 A
- US 4068091 A
- US 4139655 A
- US 4161478 A
- US 4231951 A
- US 4256828 A


### Non-patent literature cited in the description


- Chemistry of Catalyst Preparation. Kodansha Scientific, 1982, 49
- **W. R. Watt et al.** *Journal of Polymer Science, Polymer Chemistry,* 1984, vol. 22, 1789
- **R.R. Alm.** *Modern Coatings,* October 1980